Europäisches Patentamt

European Patent Office

Office européen des brevets

(11) Veröffentlichungsnummer : **0 071 560**
**B1**

# (12) EUROPÄISCHE PATENTSCHRIFT

(45) Veröffentlichungstag der Patentschrift :
09.10.85

(51) Int. Cl.⁴ : **G 01 R 15/06**

(21) Anmeldenummer : 82730086.4

(22) Anmeldetag : 25.06.82

(54) Hochspannungsmesseinrichtung mit einem kapazitiven Teiler in einem Isoliergas gefüllten Behälter.

(30) Priorität : 24.07.81 DE 3129901

(43) Veröffentlichungstag der Anmeldung :
09.02.83 Patentblatt 83/06

(45) Bekanntmachung des Hinweises auf die Patenterteilung : 09.10.85 Patentblatt 85/41

(84) Benannte Vertragsstaaten :
BE CH DE FR GB LI NL SE

(56) Entgegenhaltungen :
DE-A- 2 313 401
FR-A- 2 102 531
GB-A- 1 058 890

(73) Patentinhaber : Siemens Aktiengesellschaft
Berlin und München Wittelsbacherplatz 2
D-8000 München 2 (DE)

(72) Erfinder : Freygang, Hans-Joachim, Dipl.-Ing.
Albestrasse 26
D-1000 Berlin 41 (DE)
Erfinder : Müller, Willi, Dr.-Ing.
Am Kinderdorf 51
D-1000 Berlin 22 (DE)
Erfinder : Weniger, Manfred, Dr.-Ing.
Schuckertdamm 342
D-1000 Berlin 13 (DE)

EP 0 071 560 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Beschreibung

Die Erfindung bezieht sich auf eine Hochspannungsmeßeinrichtung mit einem kapazitiven Spannungsteiler in einem mit Isoliergas gefüllten Behälter, bei der der Oberspannungskondensator aus einem an einer Hochspannung liegenden Leiter und einer diesen umgebenden Meßelektrode und der Unterspannungskondensator aus der Meßelektrode und einer diese umgebenden Niederspannungselektrode besteht.

Bei einer bekannten Hochspannungsmeßeinrichtung dieser Art (DE-A1-22 15 928) umschließt die Meßelektrode die Hochspannungselektrode zur Erzielung einer großen Kapazität nahezu vollständig ; der Unterspannungskondensator des kapazitiven Spannungsteilers bildet mit dem Oberspannungskondensator eine konstruktive Einheit und ist von der Meßelektrode und einer sie vollständig oder nahezu vollständig umgebenden, geerdeten Elektrode gebildet. Durch diese Ausbildung von Meßelektrode und der sie umgebenden, geerdeten Elektrode ist ein kapazitiver Spannungsteiler gewonnen, bei dem auch der Unterspannungskondensator einen verhältnismäßig großen Kapazitätswert aufweist. Die Spannung wird demzufolge bei dieser bekannten Hochspannungsmeßeinrichtung so weit heruntergeteilt, daß an den Unterspannungskondensator ein übliches Meßgerät oder eine herkömmliche Schutzeinrichtung angeschlossen werden kann. Die Ausbildung von Meßelektrode und geerdeter Elektrode ist aber verhältnismäßig kompliziert, so daß die Herstellung der bekannten Hochspannungsmeßeinrichtung relativ aufwendig ist.

Der Erfindung liegt daher die Aufgabe zugrunde, eine Hochspannungsmeßeinrichtung mit einem kapazitiven Teiler in einem mit Isoliergas gefüllten Behälter vorzuschlagen, die mit verhältnismäßig geringem Aufwand herstellbar ist.

Zur Lösung dieser Aufgabe ist bei einer Hochspannungsmeßeinrichtung der eingangs angegebenen Art erfindungsgemäß die Meßelektrode als ein Ring einer bestimmten Breite ausgebildet und die Niederspannungselektrode ist als ein weiterer Ring mit einer Breite ausgebildet, die etwa der Breite des Ringes der Meßelektrode entspricht ; mit der Meßelektrode ist mindestens ein aktiver Spannungsteiler verbunden, an dessen Verstärker ausgangsseitig eine der Hochspannung proportionale Spannung auftritt.

Ein wesentlicher Vorteil der erfindungsgemäßen Hochspannungsmeßeinrichtung besteht darin, daß bei ihr sowohl die Meßelektrode als auch die sie umgebende Niederspannungselektrode verhältnismäßig einfach ausgebildet sind, weil sie lediglich als Ringe ausgeführt sind. Kompliziert gestaltete Elektroden in Topfform, wie sie bei der bekannten Hochspannungsmeßeinrichtung benötigt werden, sind also bei der erfindungsgemäßen Hochspannungsmeßeinrichtung nicht erforderlich. Der Mangel des aus zwei Ringen und einem an Hochspannung liegenden Leiter gebildeten kapazitiven Teilers, daß nämlich der Unterspannungskondensator eine verhältnismäßig kleine Kapazität besitzt, ist in einfacher Weise dadurch behoben, daß an die Meßelektrode ein aktiver Spannungsteiler angeschlossen ist. Mittels dieses aktiven Spannungsteilers gelingt es, die verhältnismäßig hohe Spannung am Unterspannungskondensator des kapazitiven Teilers so weit herunterzuteilen, daß die am Eingang des Verstärkers des aktiven Spannungsteilers auftretende Spannung nahezu Null ist. Im Vergleich zu der bekannten Meßeinrichtung ist bei erfindungsgemäßer Hochspannungsmeßeinrichtung auch der Vorteil vorhanden, daß das Teilerverhältnis des kapazitiven Teilers durch Temperatur- oder Druckänderungen nicht beeinflußt ist, weil sich sowohl der Ober- als auch der Unterspannungskondensator des kapazitiven Teilers in dem mit Isoliergas gefüllten Behälter befinden und damit in gleicher Weise bei Temperatur- oder Druckänderungen des Isoliergases ihre Kapazität verändern.

Es ist zwar bereits bekannt (« Smit-Mededelingen » 24, 1969, Nr. 4, Seiten 223 bis 232), bei einer Hochspannungsmeßeinrichtung mit einem kapazitiven Teiler einem an Hochspannung liegenden Leiter eine ringförmige Meßelektrode zuzuordnen, die mit dem Leiter den Oberspannungskondensator des kapazitiven Teilers bildet, jedoch ist bei dieser bekannten Meßeinrichtung der Unterspannungskondensator des kapazitiven Teilers außerhalb eines mit Isoliergas gefüllten Behälters untergebracht, so daß das Teilerverhältnis von Temperatur- und Druckunterschieden im Behälter und außerhalb des Behälters nicht unbeeinflußt ist. Der Unterspannungskondensator der bekannten Meßeinrichtung liegt übrigens im Gegenkopplungszweig eines Verstärkers und bildet somit zusammen mit dem Oberspannungskondensator einen aktiven Spannungsteiler.

Es wird bei der erfindungsgemäßen Hochspannungsmeßeinrichtung als vorteilhaft angesehen, wenn auch der Oberspannungskondensator des aktiven Spannungsteilers im Behälter untergebracht ist. Damit wird der Vorteil erzielt, daß die Verbindung des Oberspannungskondensators mit dem Eingang des Verstärkers des aktiven Spannungsteilers mittels einer verhältnismäßig einfach gestalteten Durchführung im Behälter erfolgen kann, weil diese Durchführung nur durch eine sehr niedrige Spannung beansprucht wird.

Ferner hat es sich als vorteilhaft erwiesen, wenn bei der erfindungsgemäßen Hochspannungsmeßeinrichtung an den Verstärker des aktiven Spannungsteilers eingangsseitig mit einem Anschluß ein Zusatzkondensator angeschlossen ist, dessen weiterer Anschluß geerdet ist. An diesen Zusatzkondensator läßt sich dann in einfacher Weise beispielsweise der zeitliche Verlauf der zu erfassenden Spannung mittels eines Oszillographen überwachen. Außerdem wird bei Unterbrechung eines Übertragungkabels zum Verstärker das Auftreten einer hohen Spannung an der Durchführung vermieden, wenn der Zusatzkondensator in vorteilhafter Weise in unmittelbarer Nähe der Durchführung angeordnet wird.

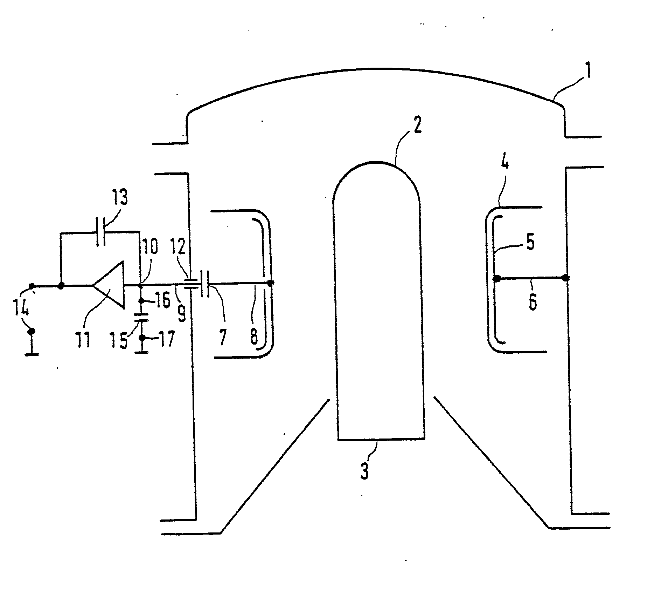

Zur Erläuterung der Erfindung ist in der Figur ein Ausführungsbeispiel der erfindungsgemäßen Hochspannungsmeßeinrichtung schematisch dargestellt.

Die gezeigte Hochspannungsmeßeinrichtung weist einen Behälter 1 auf, der mit Isoliergas, beispielsweise $SF_6$, gefüllt ist. Innerhalb des im dargestellten Beispiel zylindrisch ausgebildeten topfartigen Behälters 1 ist ein an Hochspannung liegender Leiter 2 angeordnet, der an seinem in der Figur unteren Ende 3 in nicht dargestellter Weise an Hochspannung angeschlossen ist. Der Leiter 2 ist von einer Meßelektrode 4 umgeben, die als ein Ring mit nach außen gezogenen Enden ausgebildet ist. Die Meßelektrode 4 bildet mit dem Leiter 2 einen Oberspannungskondensator eines kapazitiven Teilers.

Die Meßelektrode 4 ist außen von einer Niederspannungselektrode 5 im Abstand umgeben. Diese Niederspannungselektrode 5 bildet mit der Meßelektrode 4 einen Unterspannungskondensator des kapazitiven Teilers. Die Niederspannungselektrode 5 ist deshalb über eine Verbindungsleitung 6 mit dem geerdeten Behälter 1 verbunden. Die Niederspannungselektrode 5 ist als weiterer Ring ausgebildet und stimmt in ihrer Breite etwa mit der Meßelektrode 4 überein.

Innerhalb des Behälters 1 befindet sich zusätzlich ein Kondensator 7, der nicht — wie der Ober- und Unterspannungskondensator des kapazitiven Teilers — als Dielektrikum das Isoliergas im Behälter 1 aufweist, sondern beispielsweise als Feststoffkondensator ausgeführt ist. Der Kondensator 7 ist einerseits über eine Verbindungsleitung 8 mit der Meßelektrode 4 verbunden und andererseits über eine Verbindungsleitung 9 mit dem Eingang 10 eines Verstärkers 11 verbunden. Dabei ist die Verbindungsleitung 9 mittels einer Durchführung 12 herausgeführt, die nur niederspannungsmäßig beansprucht wird.

Der Verstärker 11 ist über einen weiteren Kondensator 13 gegengekoppelt, so daß von dem Verstärker 11, dem Kondensator 13 und dem Kondensator 7 ein aktiver Spannungsteiler gebildet ist. Am Ausgang 14 des Verstärkers 11 bzw. des aktiven Spannungsteilers ist dann eine Spannung abgreifbar, die der Hochspannung am Leiter 2 proportional ist.

Da die Spannung am Eingang 10 des Verstärkers 11 des aktiven Spannungsteilers nahezu Null ist, gehen Kapazitäten der Verbindungsleitung 9 zwischen dem Kondensator 7 und dem Eingang 10 des Verstärkers in das Meßergebnis nicht ein. Deshalb ist es ohne Verursachung eines Meßfehlers möglich, an den Eingang 10 des Verstärkers 11 oder in unmittelbar Nähe der Durchführung 12 einen Zusatzkondensator 15 anzuschließen und über Anschlüsse 16 und 17 beispielsweise mittels eines Oszillographen die Spannung zu überwachen.

## Patentansprüche

1. Hochspannungsmeßeinrichtung mit einem kapazitiven Spannungsteiler in einem mit Isoliergas gefüllten Behälter (1), bei der der Oberspannungskondensator aus einem an einer Hochspannung liegenden Leiter (3) und einer diesen umgebenden Meßelektrode (4) und der Unterspannungskondensator aus der Meßelektrode (4) und einer diese umgebenden Niederspannungselektrode (5) besteht, dadurch gekennzeichnet, daß die Meßelektrode (4) als ein Ring einer bestimmten Breite ausgebildet ist, daß die Niederspannungselektrode (5) als ein weiterer Ring mit einer Breite ausgebildet ist, die etwa der Breite des Ringes der Meßelektrode (4) entspricht, und daß mit der Meßelektrode (4) mindestens ein aktiver Spannungsteiler (7, 11, 13) verbunden ist, an dessen Verstärker (11) ausgangsseitig eine der Hochspannung proportionale Spannung auftritt.

2. Hochspannungsmeßeinrichtung nach Anspruch 1, dadurch gekennzeichnet, daß der Oberspannungskondensator (7) des aktiven Spannungsteilers (7, 11, 13) im Behälter (1) untergebracht ist.

3. Hochspannungsmeßeinrichtung nach Anspruch 1 oder 2, dadurch gekennzeichnet, daß an den Verstärker (11) des aktiven Spannungsteilers (7, 11, 13) eingangsseitig mit einem Anschluß (16) ein Zusatzkondensator (15) angeschlossen ist, dessen weiterer Anschluß (17) geerdet ist.

## Claims

1. A high voltage measuring device having a capacitive voltage divider in a container (1) filled with insulating gas, in which the high voltage capacitor consists of a conductor (3) which is at a high voltage, and a measuring electrode (4) which surrounds said conductor, and the low voltage capacitor consists of the measuring electrode (4) and a low voltage electrode (5) which surrounds said measuring electrode, characterised in that the measuring electrode (4) is in the form of a ring having a predetermined width ; that the low voltage electrode (5) is in the form of a further ring having a width which corresponds approximately to the width of the ring of the measuring electrode (4) ; and that the measuring electrode (4) is connected to at least one active voltage divider (7, 11, 13), at the outlet of the amplifier (11) of which, a voltage appears which is proportional to the high voltage.

2. A high voltage measuring device as claimed in Claim 1, characterised in that the high voltage capacitor (7) of the active voltage divider (7, 11, 13) is accommodated in the container (1).

3. A high voltage measuring device as claimed in Claim 1 or Claim 2, characterised in that the amplifier (11) of the active voltage divider (7, 11, 13) is connected at its input end by a terminal (16) to an additional capacitor (15) the other terminal (17) of which is earthed.

**Revendications**

1. Dispositif de mesure de haute tension, comportant un diviseur de tension capacitif dans un récipient (1) rempli de gaz isolant, dont le condensateur à tension supérieure est formé d'un conducteur (3) présentant la haute tension et d'une électrode de mesure (4) qui l'entoure et dont le condensateur à tension inférieure est formé de l'électrode de mesure (4) et d'une électrode basse tension (6) qui l'entoure, caractérisé en ce que l'électrode de mesure (4) est réalisée comme un anneau d'une certaine largeur, que l'électrode basse tension (5) est réalisée comme un autre anneau dont la largeur correspond à peu près à celle de l'anneau de l'électrode de mesure (4) et que l'électrode de mesure (4) est reliée à au moins un diviseur de tension actif (7, 11, 12), à la sortie de l'amplificateur (11) duquel apparaît une tension proportionnelle à la haute tension.

2. Dispositif selon la revendication 1, caractérisé en ce que le condensateur à tension supérieure (7) du diviseur de tension actif (7, 11, 13) est logé dans le récipient (1).

3. Dispositif selon la revendication 1, caractérisé en ce qu'un condensateur supplémentaire (15) est relié par une borne (16) à l'entrée de l'amplificateur (11) du diviseur de tension actif (7, 11, 13), l'autre borne (17) de ce condensateur étant reliée à la terre.